# EUROPEAN PATENT SPECIFICATION

(11) **EP 4 123 274 B1**
(45) Date of publication and mention of the grant of the patent: **04.06.2025**
(21) Application number: 21306013.0
(22) Date of filing: 19.07.2021
(51) Int. Cl.: G01K 1/143, G01K 1/16, G01K 7/22, H05K 1/02

(54) **SENSOR WITH PRINTED CIRCUIT BOARD BASED CONTACT**
SENSOR MIT LEITERPLATTENBASIERTEM KONTAKT
CAPTEUR AVEC CONTACT BASÉ SUR UNE CARTE DE CIRCUIT IMPRIMÉ

(43) Date of publication of application: 25.01.2023
(73) Proprietor: TE Connectivity Sensors France, 31027 Toulouse Cedex 3 (FR)
(72) Inventor: DURUPT, Emilien, 31027 Toulouse (FR); VIDAL, Yannick, 31027 Toulouse (FR); LEGER, Vincent, 31027 Toulouse (FR)
(74) Representative: Grünecker Patent- und Rechtsanwälte PartG mbB

(56) References cited:
- EP-A1- 3 885 168
- WO-A1-2020/105881
- DE-A1- 102011 004 174
- US-A1- 2007 093 084
- US-A1- 2008 212 645
- US-A1- 2020 408 607

## Description

The invention relates to a sensor comprising a printed circuit board with a parameter sensing element. In particular, the invention relates to a thermal sensor with a temperature sensing element.

To be able to sense a physical parameter of a probe, the sensing element of certain sensors need to be in a safe and reliable physical contact with the probe. This is particularly the case for thermal sensors that comprise a temperature sensing element mount on a printed circuit board that is encapsulated in a housing. They are widely used to determine the temperature of a probe or device. For instance, thermal sensors find their application in vehicles to measure the temperature of various parts. As an example, thermal sensors are used to measure the temperature of a windscreen to be able to preview the risk of fogging or icing and to provide suitable control signals to the air condition.

To function properly a stable thermal contact is needed between the temperature sensing element of the thermal sensor and the surface to be temperature probed. In the prior art sensor devices, this is achieved using additional parts such as thermally conductive pads attaching the sensor to the surface, or flexing elements, like springs, that push the temperature sensing element against the surface to be measured. DE 10 2011 004174 A1 discloses a PCB (14) supporting a temperature or pressure sensor (22). When the PCB is mounted on a holder (12), the sensor is pushed against the surface of the object (28) to be measured.

Starting therefrom, it is the object of the present invention to provide an alternative solution ensuring the contact of a sensor with the surface to be probed which does not need an additional part. It is, in particular, the object of the present invention to provide an alternative solution ensuring the contact of a sensor with the surface to be probed which does not need an additional part.

This object is achieved with the sensor according to claim 1.

The object is in particular achieved with a temperature sensor comprising the printed circuit board wherein the physical parameter sensing element is a temperature sensing element. By providing a flexible linking portion that is part of the printed circuit board itself, it is no longer necessary to provide additional parts to ensure a reliable contact, e.g. thermal contact in the case of a temperature sensor according to the invention. This reduces the bill of material as well as the manufacturing costs. The flexible linking portion allows a movement of the free end portion with respect to the second region, in particular in the plane of the printed circuit board. This resilience can be used to ensure securely the contact with a surface to be sensed. In particular, this resilience can be used to ensure securely the thermal contact with a surface to be temperature sensed.

According to an embodiment, the printed circuit board can comprises a cutout region between the first region and the second region to form the flexible linking portion. By cutting out a part of the printed circuit board between the first and second region, the printed circuit board presents a mechanically weakened area. Due to the elastic properties of the material of the printed circuit board, the mechanically weakened area allows a flexing movement of the first region with respect to the second region, in particular in the plane of defined by the main surface of the printed circuit board. Preferably, the cut out is realized such that flexible linking portion comprises area with a concavely rounded shape to facilitate the flexing movement of the first region with respect to the second region. According to one example, the printed circuit board can be made of the so called FR4 epoxy laminate (Flame retardant 4) which is commonly used, but could also be of any other suitable material like phenolic resins. The dimensions of the cutout will be chosen such that the desired resilience for a given thickness of the printed circuit board and definition of the layers of the circuit board is obtained such that a predetermined plating force is observed taking into account the vibratory conditions of the application. According to the invention, the first region can comprise a metallized edge region, preferably thermally connected to the temperature sensing element. The metallized edge region allows a reliable thermal contact with the surface to be temperature probed.

According to an embodiment, the metallized edge region can be on a side of the first region facing away from the second region. By arranging the metallized edge region on the side away from the second region, the access to the metallized edge region is simplified so that a reliable thermal contact can be realized with any object.

According to an embodiment, the metallized edge region can be positioned at an extremity of the first region opposite the flexible linking portion. At the extremity of the first region opposite the flexible linking portion, the elastic forces occurring following a deformation are higher than in regions closer to the flexible linking portion.

According to the invention, the first region comprises a first protruding region in the plane of the printed circuit board that is protruding away from the second region and comprises the metallized edge region. Providing such a protruding portion can further improve the contact with a surface to be probed, in particular the thermal contact with a surface to be temperature probed.

According to an embodiment, the first region can have a zigzag shape. Such a shape can further improve the spring like behavior of the first region with respect to the second region.

According to an embodiment, the temperature sensor can comprise a thermistor, in particular a NTC provided on the first region, in particular on the first protruding region. In this arrangement, an improved thermal contact with the surface to be temperature probed can be realized.

According to an embodiment, the thermistor can be electrically connected to one or more electrical components provided on the second region of the printed circuit board. By spatially separating the thermistor from the other electrical components of the temperature sensor, the temperature sensing is less disturbed by heat of the electrical components.

According to an embodiment, the first region can comprise a second protruding region in the plane of the printed circuit board that is protruding towards the second region. The second protruding region forms a stopping element that limits the extent of the possible movement of the first region with respect to the second region when the stopping element abuts against the second region.

According to an embodiment, the first region of the printed circuit board can extend at least partially through and beyond a through hole in a housing enclosing the remainder of the printed circuit board. Once the sensor is mount to a surface to be sensed, e.g. the temperature sensor mount to the surface to be temperature sensed, the part of the first region that extends beyond the through hole will ensure a reliable thermal contact.

According to an embodiment, the metallized edge region can extend at least partially beyond the through hole in the housing. Thus, a reliable contact, in particular thermal contact, can be ensured.

According to an embodiment, the flexible linking portion can be configured to allow a movement of the first region with respect to the second region in the plane defined by the printed circuit board. The flexible material properties of the printed circuit board can be used to realize a reliable contact with a surface to be probed without the need of any additional element. It is in particular possible to realize a reliable thermal contact with a surface to be temperature probed when using the invention for a temperature sensor.

According to an embodiment, the length of the first region, extending from the flexible linking portion to the extremity of the free end portion, can have a length larger than the width of the first region at the intersection with the flexible linking portion. This further improves the flexibility of the first region and therefore the reliability of contact.

According to an embodiment, the first region can comprise an arm region between the flexible linking portion and the free end portion, wherein the arm region has a tapered shape such that its width at the intersection with the flexible linking portion is larger than its width at the intersection with the free end portion. The tapered shape can distribute the mechanical stress over the extension of the arm region.

The object of the invention is also achieved with a printed circuit board for use in a sensor characterized in comprising a first and second region linked by a flexible linking portion. With such a printed circuit board, all technical effects and advantages as described above can be achieved.

The object of the invention is also achieved with the device according to claim 17, comprising a sensor according to any one of the realizations as described above wherein the sensor is mount to a surface of an element of the device, characterized in that the housing of the sensor is positioned such with respect to the surface of the element that the first region is in a preloaded state and thereby pressed against the surface of the element. Using the inventive sensor it thus becomes possible to realize reliably a contact with the surface of the element without needing an additional element besides the printed circuit board shaped according to the invention. This is particularly advantageous when probing the temperature when the sensor is configured as a temperature sensor using a temperature sensing element.

The invention may be understood by reference to the following description taken in conjunction with the accompanying figures, in which reference numerals identify features of the invention.
Figure 1 illustrates a first embodiment of a temperature sensor according to the invention not yet mount to an object to be temperature sensed.
Figure 2 illustrates the first embodiment of a temperature sensor according to the invention mount to an object to be temperature sensed.
Figure 3 illustrates the printed circuit board 3 of the temperature sensor according to a second embodiment of the invention before being mount into a housing.
Figure 4 illustrates a second embodiment of the printed circuit board according to the invention.

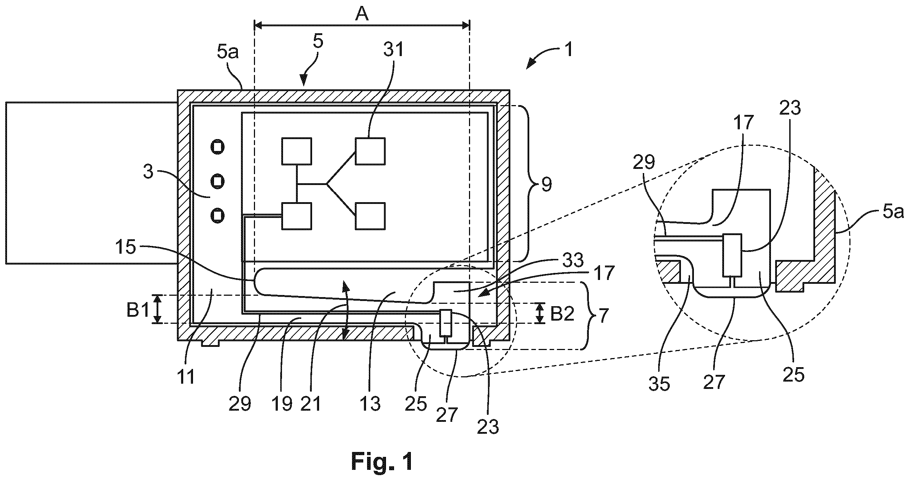

Figure 1 illustrates a first embodiment of a sensor according to the invention. The invention will be described in detail for temperature sensor 1. Nevertheless, the concept of ensuring a reliable contact between the senor and the surface to be probed can be applied to other kinds of sensors sensing one or more other physical parameters.

The temperature sensor 1 comprises a printed circuit board 3 positioned inside a housing 5. Figure 1 illustrates a view onto one main surface of the printed circuit board 3 placed into the housing 3 which is illustrated with a cut view through its lateral walls 3a. In Figure 1, the temperature sensor 1 is not yet mounted to an object to be temperature sensed.

The printed circuit board 3 comprises a first region 7 and second region 9 which are spaced apart from each other on one side and linked together via a flexible linking portion 11. According to the invention, the flexible linking portion 11 is an integrally part of the printed circuit board 3.

To form the flexible linking portion 11, a cut-out region 13 is provided in the printed circuit board 3. The cut-out region 13 is realized such that the flexible linking portion 11 comprises an area 15 with concavely rounded shape.

The first region 7 comprises a head portion 17 and an arm portion 19 linking the head portion 17 at the end of the first region 7 to the flexible linking portion 11. The head portion 17 at the extremity of the first region 7, also called the free end portion, is thus opposite to the flexible linking portion 11.

The cut-out region 13 mechanically weakens the printed circuit board 3 and provides the necessary elasticity so that the head portion 17 at the extremity of first region 7 can be moved relatively to the second region 9 in the plane formed by the printed circuit board 3. In other words, the first region 7 behaves like a spring, indicated by arrow 21. The mechanical principle can be realized with many materials. The printed circuit board can e.g. be made of the widely used FR4 epoxy laminate (Fiber Reinforced 4), but could also be made of any other suitable material like phenolic resins.The dimensions of the cut out region 13 and the material used determine the resulting forces and the vibratory resistance. The Young modulus of the material is preferably in a range of 2GPa to 300GPa. The needs of heat dissipation and conduction can also be taken into account.

The head portion 17 comprises a temperature sensing element 23, e.g. in the form of a thermistor, like a negative temperature coefficient (NTC) thermistor.

The head portion 17 has a first protruding region 25 in the plane of the printed circuit board that is protruding away from the second region 9 and comprises a metallized edge region 27. The temperature sensing element 23 is in thermal contact with the metallized edge region 27, which is facing away from the second region 9.

The temperature sensing element 23 is electrically connected via a metallic track 29 to one or more electrical components 31 provided on the second region 9 of the printed circuit board 3.

The head portion 17 furthermore comprises a second protruding region 33 in the plane of the printed circuit board 3 that is protruding towards the second region 9 and serves as a stopping element limiting the course of movement of the head portion 17 towards the second region 9, as will be described further down.

The enlarged zone in Figure 1 illustrates that the first protruding portion 25 of the head portion 17 of the first region 7 of the printed circuit board 3 extends at least partially through and beyond a through hole 35 in the housing 3 enclosing the remainder of the printed circuit board 3.

In this embodiment, the metallized edge region 27 extends beyond the through hole 35 in the housing 3 towards the outside.

Preferably, the length A of the first region, thus the length of the head portion 17 plus the arm portion 19 as illustrated in Figure 1, can be larger than the width B1of first region 7, thus the arm portion 19, at the transition to the flexible linking portion 11. Even further preferred, the length A should satisfy A > 3*B1. Preferably, the arm region has a tapered shape, such that the width B1, perpendicular to the length A, of the arm portion 19 at the transition to the flexible linking portion 11 is larger than the width B2 at the transition to the head portion 17 to distribute the mechanical stress over the length of the arm portion 19.

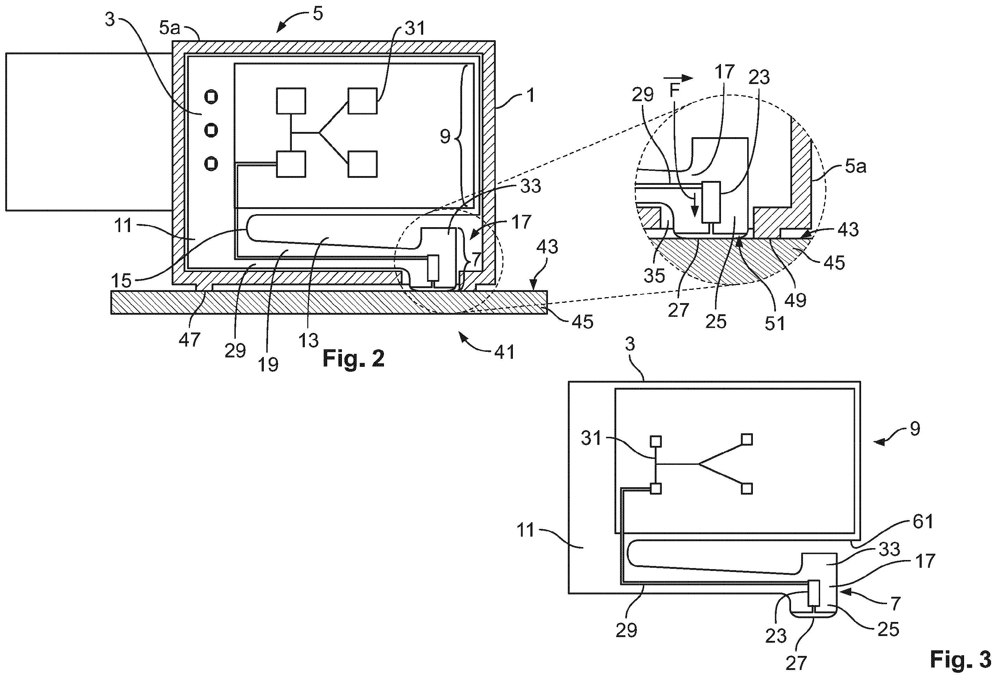

Figure 2 illustrates a device 41 comprising the temperature sensor 1 of the first embodiment. In the device 41, e.g. a vehicle, the temperature sensor 1 is mount to a surface 43 of an element 45 of the device. As an example, the element 45 can be the windscreen of a vehicle and the temperature sensor 1 is mount onto the inside surface 43 of the windscreen.

Features with reference numerals already used in the description of the temperature sensor 1 illustrated in Figure 1 will not be described again in detail, but reference is made to their description in Figure 1.

When mounting the temperature sensor 1 onto the surface 43, the feet 47 and 49 of the housing 5 rest on the surface 43. Mounting can be realized in several ways, e.g. by gluing, clipping using a spring element to hold the sensor in place or by locking the sensor using an additional locking element. During the step of mounting of the temperature sensor 1, the first protruding portion 25 of the first region 7 is pushed towards the housing such that the extremity 51 of the metallized edge regions 27 becomes flush aligned with the extremity of the foot 49. This becomes possible due to the elasticity of the arm portion 19 of first region 7. Due to elastic property of the first region 7, the extremity 51 of the metallized edge region 27 is pressed against the surface 43 by the elastic restoring force, illustrated by arrow F. In other words, the head portion 17 of the first region 7 is in a preloaded state. Thus, the thermal contact between the metallized edge region 27 and the element 45 to be temperature sensed can be ensured in a simple and reliable manner.

Thus, thanks to the flexible shape design of the printed circuit board made out of an intrinsically flexible material, a preloaded thermal contact can be ensured between the temperature sensor and the object to be temperature sensed. This thermal contact can thus be realized without the need of any additional elements like additional springs, flex elements or thermal pads, thereby reducing cost of manufacturing and reducing the bill of materials.

Figure 3 illustrates the printed circuit board 3 according to the invention before being mount into a housing as illustrated in Figure 1 and 2 by reference numeral 5. The printed circuit board 3 of Figure 3 has all the features of the printed circuit board as already described with respect to Figures 1 and 2 to which reference is made.

The second protruding portion 33 reduces risk of breakage of the printed circuit board as the travel of the head portion 17 towards the second region 9 can be kept small. Indeed, the movement of the head portion 17 at the end portion of the first region 7 is stopped when the second protruding region touches 33 the edge 61 of the second region 9.

Here, the printed circuit board 3 is illustrated with all elements mount, e.g. the temperature sensing element 23, the electrical components 31 and the electrically and thermally conductive traces 29, 27. The invention is, however, not limited thereto and also relates to the printed circuit board 3 alone.

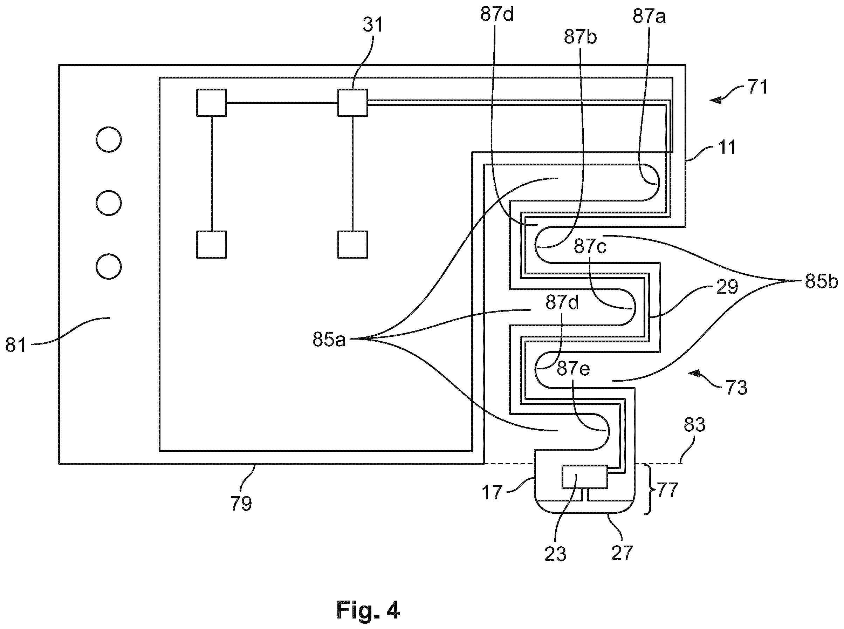

Figure 4 illustrates a third embodiment according to the invention. The printed circuit board 71 according to the third embodiment has a second region 73 that is zigzag shaped between the flexible linking portion 11 and the head portion 75 instead of using an arm shaped portion 19 like in the first and second embodiment. Features carrying the same reference numerals as already used in the first and second embodiment will not be described again in detail but reference is made thereto.

Here, the zig zag shaped first region 73 is realized by a succession of U-shaped elements, which is an example shape only. Other shapes, like V-shaped elements or alternating U and V shape elements could also build up the first region 73.

The head portion 75 comprises a protruding portion 77 extending beyond edge 79 of the first region 81 of the printed circuit board 71, which is indicated by the dotted lines 83. At the extremity of the protruding portion 77 farthest away from the flexible linking portion 11, a metalized edge region 27 is provided like in the first and second embodiment.

The metalized edge region 27 is in thermal contact with the temperature sensing element 23 in turn electrically connected via the electrical connection 29 with further electrical elements 31 provided on the second region 81.

The cut outs 85a and 85b to remove printed circuit board material to weaken mechanically to printed circuit board to obtain the shape as illustrated in Figure 4 are realized such that the corners on the inner sides 87a-e of the U shaped elements all have rounded shapes.

The printed circuit board 75 can be positioned in a housing 5 like in the first embodiment such that the metallized edge region 27 extends beyond the trough hole 35. In the mount state the metallized edge region 27 can be pushed towards the inside of the housing comparable to what is illustrated in Figure 2 which is due to the spring like behavior of the zig zag shaped first region 73 and the flexible linking portion 11.

Thus, the same advantageous can be achieved with the printed circuit board 71 of the third embodiment like with the printed circuit board 3 as illustrated in Figure 3.

A number of embodiments of the invention have been described. Nevertheless, it is understood that various modifications and enhancements may be made without departing the following claims.

### REFERENCE NUMERALS

- 1: temperature sensor according to the first embodiment
- 3: printed circuit board (PCB)
- 5: housing
- 5a: side walls of housing
- 7: first region
- 9: second region
- 11: flexible linking portion
- 13: cut-out portion
- 15: area of flexible linking portion with a concavely rounded shape
- 17: head portion, free end portion
- 19: arm portion
- 21: spring like behaviour
- 23: temperature sensing element
- 25: first protruding region
- 27: metallized edge region
- 29: metallic track
- 31: electrical component(s)
- 33: second protruding region
- 35: through hole in housing 3
- 41: device
- 43: surface of element 45
- 45: element of device 41
- 47: foot
- 49: foot
- 51: extremity of metallized edge region 27
- 61: edge of second region 11
- 71: temperature sensor according to the third embodiment
- 73: zigzag shaped first region
- 75: head portion
- 77: protruding portion
- 79: edge of second region
- 81: second region
- 83: dotted lines
- 85a,b: cut outs
- 87a-e: rounded shape

## Claims

1. Sensor, in particular temperature sensor, comprising a printed circuit board (3) with a physical parameter sensing element (23), in particular a temperature sensing element, wherein the printed circuit board (3, 71) comprises a first region (7, 73) and a second region (9, 81) linked together via a flexible linking portion (11) such that a free end portion (17) of the first region (7) opposite the flexible linking portion (11) is moveable with respect to the second region (9),
wherein the flexible linking portion (11) is part of the printed circuit board (3), the sensor being **characterised in that** the first region (7, 73) comprises a first protruding region (25) in the plane of the printed circuit board (3) that is protruding away from the second region (9) and comprises a metallized edge region (27).

2. Sensor according to claim 1, **characterized in that** the printed circuit board (3) comprises a cutout region (13) between the first region (7, 73) and second region (9) to form the flexible linking portion (11).

3. Sensor according to claim 1 or 2, wherein the metallized edge region (27) is on a side of the first region (7) facing away from the second region (9).

4. Sensor according to one of claims 1 to 3, wherein the metallized edge region (27) is positioned at the free end portion (17) of the first region (7, 73) opposite the flexible linking portion (11).

5. Sensor according to one of claims 1 to 4, wherein the first region (73) is zigzag shaped.

6. Sensor according to one of claims 1 to 5, wherein the temperature sensing element (23) a thermistor, in particular a NTC, provided on the first region (7), in particular on the first protruding region (25).

7. Sensor according to claim 6, wherein the thermistor is electrically connected to one or more electrical components (31) provided on or over the second region (9) of the printed circuit board (3).

8. Sensor according to one of claims 1 to 7, wherein the first region (7) comprises a second protruding region (33) in the plane of the printed circuit board (3) that is protruding towards the second region (9).

9. Sensor according to one of claims 1 to 8, comprising a housing (5) and wherein the first region (7) of the printed circuit board (3) extends at least partially through and beyond a through hole (35) in the housing (5) enclosing the remainder of the printed circuit board (3).

10. Sensor according to claim 9, wherein the metallized edge region (27) extends beyond the through hole (35) in the housing (5).

11. Sensor according to one of claims 1 to 10, wherein the flexible linking portion (11) is configured to allow a movement of the first region (5) with respect to the second region (7) in the plane defined by the printed circuit board (3).

12. Sensor according to one of claims 1 to 11, wherein a length (A) of the first region (7) extends from the flexible linking portion (11) to the extremity of the free end portion (17), and the length (A) is larger than the width (B1) of the first region (7) at the intersection with the flexible linking portion (11).

13. Sensor according to one of claims 1 to 12, wherein the first region (7) comprises an arm region (19) between the flexible linking portion (11) and the free end portion (17), wherein the arm region has a tapered shape such that its width (B1) at the intersection with the flexible linking portion (11) is larger than its width (B2) at the intersection with the free end portion (17).

14. Device comprising a sensor according to one of claims 1 to 13 wherein the sensor (1) is mount to a surface (43) of an element (45) of the device, **characterized in that** a housing (5) of the sensor is positioned such with respect to the surface of the element that the first region (7) is in a preloaded state and thereby pressed against the surface (43) of the element (45).

## Patentansprüche

1. Sensor, insbesondere Temperatursensor, mit einer Leiterplatte (3) mit einem physikalischen Parameter-Sensorelement (23), insbesondere einem Temperatursensorelement, wobei die Leiterplatte (3, 71) einen ersten Bereich (7, 73) und einen zweiten Bereich (9, 81) umfasst, die über einen flexiblen Verbindungsabschnitt (11) miteinander verbunden sind, so dass ein freier Endabschnitt (17) des ersten Bereichs (7) gegenüber dem flexiblen Verbindungsabschnitt (11) in Bezug auf den zweiten Bereich (9) beweglich ist,
wobei der flexible Verbindungsabschnitt (11) Teil der Leiterplatte (3) ist, wobei der Sensor **dadurch gekennzeichnet ist, dass** der erste Bereich (7, 73) einen ersten vorstehenden Bereich (25) in der Ebene der Leiterplatte (3) umfasst, der von dem zweiten Bereich (9) weg vorsteht und einen metallisierten Kantenbereich (27) umfasst.

2. Sensor nach Anspruch 1, **dadurch gekennzeichnet, dass** die Leiterplatte (3) einen ausgeschnittenen Bereich (13) zwischen dem ersten Bereich (7, 73) und dem zweiten Bereich (9) aufweist, um den flexiblen Verbindungsabschnitt (11) zu bilden.

3. Sensor nach Anspruch 1 oder 2, wobei sich der metallisierte Kantenbereich (27) auf einer Seite des ersten Bereichs (7) befindet, die von dem zweiten Bereich (9) weg weist.

4. Sensor nach einem der Ansprüche 1 bis 3, wobei der metallisierte Kantenbereich (27) an dem freien Endabschnitt (17) des ersten Bereichs (7, 73) gegenüber dem flexiblen Verbindungsabschnitt (11) angeordnet ist.

5. Sensor nach einem der Ansprüche 1 bis 4, wobei der erste Bereich (73) zickzackförmig ist.

6. Sensor nach einem der Ansprüche 1 bis 5, wobei das Temperaturerfassungselement (23) ein Thermistor, insbesondere ein NTC, ist, der auf dem ersten Bereich (7), insbesondere auf dem ersten vorstehenden Bereich (25), vorgesehen ist.

7. Sensor nach Anspruch 6, wobei der Thermistor mit einer oder mehreren elektrischen Komponenten (31) elektrisch verbunden ist, die auf oder über dem zweiten Bereich (9) der Leiterplatte (3) vorgesehen sind.

8. Sensor nach einem der Ansprüche 1 bis 7, wobei der erste Bereich (7) einen zweiten vorstehenden Bereich (33) in der Ebene der Leiterplatte (3) umfasst, der in Richtung des zweiten Bereichs (9) vorsteht.

9. Sensor nach einem der Ansprüche 1 bis 8, der ein Gehäuse (5) umfasst und bei dem sich der erste Bereich (7) der Leiterplatte (3) zumindest teilweise durch ein Durchgangsloch (35) im Gehäuse (5), das den Rest der Leiterplatte (3) umschließt, und darüber hinaus erstreckt.

10. Sensor nach Anspruch 9, wobei sich der metallisierte Kantenbereich (27) über das Durchgangsloch (35) in dem Gehäuse (5) hinaus erstreckt.

11. Sensor nach einem der Ansprüche 1 bis 10, wobei der flexible Verbindungsabschnitt (11) so konfiguriert ist, dass er eine Bewegung des ersten Bereichs (5) in Bezug auf den zweiten Bereich (7) in der durch die Leiterplatte (3) definierten Ebene ermöglicht.

12. Sensor nach einem der Ansprüche 1 bis 11, wobei sich eine Länge (A) des ersten Bereichs (7) von dem flexiblen Verbindungsabschnitt (11) zu dem Ende des freien Endabschnitts (17) erstreckt und die Länge (A) größer ist als die Breite (B1) des ersten Bereichs (7) an der Schnittstelle mit dem flexiblen Verbindungsabschnitt (11).

13. Sensor nach einem der Ansprüche 1 bis 12, wobei der erste Bereich (7) einen Armabschnitt (19) zwischen dem flexiblen Verbindungsabschnitt (11) und dem Abschnitt (17) des freien Endes umfasst, wobei der Armabschnitt eine konische Form aufweist, so dass seine Breite (B1) an der Schnittstelle mit dem flexiblen Verbindungsabschnitt (11) größer ist als seine Breite (B2) an der Schnittstelle mit dem Abschnitt (17) des freien Endes.

14. Vorrichtung mit einem Sensor gemäß einem der Ansprüche 1 bis 13, wobei der Sensor (1) an einer Oberfläche (43) eines Elements (45) der Vorrichtung angebracht ist, **dadurch gekennzeichnet, dass** ein Gehäuse (5) des Sensors in Bezug auf die Oberfläche des Elements so positioniert ist, dass sich der erste Bereich (7) in einem vorgespannten Zustand befindet und dadurch gegen die Oberfläche (43) des Elements (45) gedrückt wird.

## Revendications

1. Capteur, en particulier capteur de température, comprenant une carte de circuit imprimé (3) avec un élément de détection de paramètre physique (23), en particulier un élément de détection de température, dans lequel la carte de circuit imprimé (3, 71) comprend une première région (7, 73) et une seconde région (9, 81) reliées entre elles via une partie de liaison flexible (11) de telle sorte qu'une partie d'extrémité libre (17) de la première région (7) opposée à la partie de liaison flexible (11) est mobile par rapport à la seconde région (9),
dans lequel la partie de liaison flexible (11) fait partie de la carte de circuit imprimé (3), le capteur étant **caractérisé en ce que** la première région (7, 73) comprend une première région en saillie (25) dans le plan de la carte de circuit imprimé (3) qui fait saillie à l'opposé de la seconde région (9) et comprend une région de bord métallisée (27).

2. Capteur selon la revendication 1, **caractérisé en ce que** la carte de circuit imprimé (3) comprend une région de découpe (13) entre la première région (7, 73) et la seconde région (9) pour former la partie de liaison flexible (11).

3. Capteur selon la revendication 1 ou 2, dans lequel la région de bord métallisée (27) se trouve sur un côté de la première région (7) faisant face à l'opposé de la seconde région (9).

4. Capteur selon l'une des revendications 1 à 3, dans lequel la région de bord métallisée (27) est positionnée au niveau de la partie d'extrémité libre (17) de la première région (7, 73) en vis-à-vis de la partie de liaison flexible (11).

5. Capteur selon l'une des revendications 1 à 4, dans lequel la première région (73) est en forme de zigzag.

6. Capteur selon l'une des revendications 1 à 5, dans lequel l'élément de détection de température (23) est une thermistance, en particulier une thermistance NTC, disposée sur la première région (7), en particulier sur la première région en saillie (25).

7. Capteur selon la revendication 6, dans lequel la thermistance est connectée électriquement à un ou plusieurs composants électriques (31) disposés sur ou au-dessus de la seconde région (9) de la carte de circuit imprimé (3).

8. Capteur selon l'une des revendications 1 à 7, dans lequel la première région (7) comprend une seconde région en saillie (33) dans le plan de la carte de circuit imprimé (3) qui fait saillie vers la seconde région (9).

9. Capteur selon l'une des revendications 1 à 8, comprenant un boîtier (5) et dans lequel la première région (7) de la carte de circuit imprimé (3) s'étend au moins partiellement à travers un trou traversant (35), et au-delà de celui-ci, dans le boîtier (5) renfermant le reste de la carte de circuit imprimé (3).

10. Capteur selon la revendication 9, dans lequel la région de bord métallisée (27) s'étend au-delà du trou traversant (35) dans le boîtier (5).

11. Capteur selon l'une des revendications 1 à 10, dans lequel la partie de liaison flexible (11) est configurée pour permettre un mouvement de la première région (5) par rapport à la seconde région (7) dans le plan défini par la carte de circuit imprimé (3).

12. Capteur selon l'une des revendications 1 à 11, dans lequel une longueur (A) de la première région (7) s'étend de la partie de liaison flexible (11) jusqu'à l'extrémité de la partie d'extrémité libre (17), et la longueur (A) est supérieure à la largeur (B1) de la première région (7) à l'intersection avec la partie de liaison flexible (11).

13. Capteur selon l'une des revendications 1 à 12, dans lequel la première région (7) comprend une région de bras (19) entre la partie de liaison flexible (11) et la partie d'extrémité libre (17), dans lequel la région de bras a une forme effilée telle que sa largeur (B1) à l'intersection avec la partie de liaison flexible (11) est supérieure à sa largeur (B2) à l'intersection avec la partie d'extrémité libre (17).

14. Dispositif comprenant un capteur selon l'une des revendications 1 à 13, dans lequel le capteur (1) est monté sur une surface (43) d'un élément (45) du dispositif, **caractérisé en ce qu'**un boîtier (5) du capteur est positionné par rapport à la surface de l'élément de telle sorte que la première région (7) est dans un état préchargé et est ainsi pressée contre la surface (43) de l'élément (45).
